# FASCICULE DE BREVET EUROPEEN

(11) **EP 0 645 886 B1**
(45) Date de publication et mention de la délivrance du brevet: **01.10.1997**
(21) Numéro de dépôt: 94401911.6
(22) Date de dépôt: 29.08.1994
(51) Int. Cl.: H03K 3/57

(54) **Générateur d'allumage haute énergie notamment pour turbine à gaz**
Hochenergiezündgenerator insbesondere für eine Gasturbine
High energy ignition generator especially for a gas turbine

(30) Priorité: 28.09.1993 FR 9311520
(43) Date de publication de la demande: 29.03.1995
(73) Titulaire: SAGEM S.A., 75016 Paris (FR)
(72) Inventeur: Balland, Patrick, F-92500 Rueil Malmaison (FR)
(74) Mandataire: Fort, Jacques

(56) Documents cités:
- FR-A- 2 381 406
- FR-A- 2 636 678
- INSTRUMENTS AND EXPERIMENTAL TECHNIQUES., vol.22, no.4,2, Juillet 1979, NEW YORK US pages 1060 - 1062 ABRAMYAN ET AL 'Correction of the pulse shape of an ARKAD'EV-MARX voltage generator'

## Description

La présente invention concerne un générateur d'allumage haute énergie notamment pour turbine à gaz.

On connait déjà dans l'état de la technique, un certain nombre de générateurs d'allumage de ce type, qui comportent une source d'énergie raccordée à un circuit de charge de moyens de stockage d'énergie comprenant un condensateur de stockage et des moyens de raccordement de ces moyens de stockage à un circuit de décharge comprenant en série des moyens à inductance de récupération d'énergie et une bougie d'allumage et aux bornes duquel sont connectés des moyens de roue libre et une résistance en parallèle, de manière à engendrer des étincelles entre les électrodes de la bougie d'allumage.

On connait également dans l'état de la technique différents moyens de raccordement des moyens de stockage d'énergie au circuit de décharge.

C'est ainsi par exemple que ces moyens de raccordement peuvent être constitués par un éclateur à gaz ou encore par des organes commutateurs à semi-conducteur, tels que par exemple des thyristors.

Le remplacement des éclateurs par de tels organes commutateurs à semi-conducteur a permis d'améliorer le fonctionnement général de ces générateurs et en particulier leur fiabilité.

Cependant, l'intégration de ces organes dans un tel environnement pose un certain nombre de problèmes en raison des contraintes de fonctionnement que ce type de matériel doit supporter.

On sait par exemple du document FR-A-2 636 678 au nom de LABO INDUSTRIE que des contraintes de température de fonctionnement ont amené à prévoir des moyens de charge particuliers des moyens de stockage d'énergie pour éviter que les courants de fuite de ces organes commutateur à semi-conducteur n'entraînent la destruction de ceux-ci par auto-échauffement.

Par ailleurs, les caractéristiques de fonctionnement du générateur sont liées aux caractéristiques de fonctionnement des moyens de raccordement des moyens de stockage d'énergie au reste des circuits de ce générateur et l'on conçoit que les caractéristiques limites de fonctionnement de ceux-ci conditionnent le fonctionnement général du générateur.

En effet, ces moyens de raccordement sont connectés entre les moyens de stockage d'énergie et le reste des circuits du générateur et peuvent être constitués par un ou plusieurs organes commutateurs à semiconducteur, de sorte que soit on est obligé de limiter les caractéristiques de sortie du générateur pour les adapter aux caractéristiques de fonctionnement du ou des organes commutateurs à semi-conducteur, soit on est obligé de combiner un nombre important d'organes commutateurs à semi-conducteur pour constituer des moyens de raccordement adaptés aux caractéristiques souhaitées de sortie du générateur.

On conçoit que l'une ou l'autre de ces solutions présentent des inconvénients.

Le but de l'invention est donc de résoudre ces problèmes en proposant un générateur d'allumage qui soit simple, fiable, présentant de bonnes caractéristiques de sortie tout en n'utilisant que des moyens de raccordement présentant des caractéristiques de fonctionnement classiques.

A cet effet, l'invention a pour objet un générateur d'allumage haute énergie notamment pour turbine à gaz, du type comportant une source d'énergie raccordée à un circuit de charge de moyens de stockage d'énergie comprenant un premier condensateur de stockage et des moyens de raccordement de ces moyens de stockage à un circuit de décharge comportant en série des moyens à inductance de récupération d'énergie et une bougie d'allumage et aux bornes duquel sont connectés des moyens de roue libre et une résistance en parallèle, de manière à engendrer des étincelles entre les électrodes de la bougie, caractérisé en ce que les moyens de stockage d'énergie comprennent un second condensateur connecté en parallèle aux bornes de ces moyens de raccordement et d'au moins une partie des moyens à inductance.

L'invention sera mieux comprise à l'aide de la description qui va suivre, donnée uniquement à titre d'exemple et faite en se référant aux dessins annexés, sur lesquels :
- la Fig.1 représente un schéma synoptique illustrant la structure d'un générateur d'allumage selon l'invention; et
- la Fig.2 représente un schéma électrique équivalent du générateur représenté sur la Fig.1 lorsqu'une étincelle est amorcée entre les électrodes de la bougie.

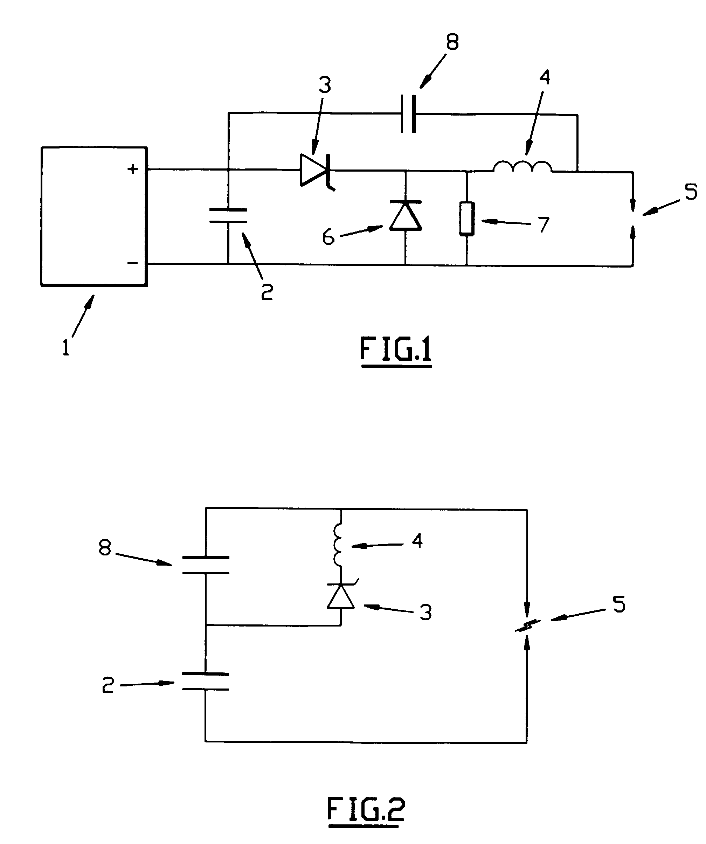

Ainsi qu'on peut le voir sur la Fig.1, un générateur d'allumage haute énergie notamment pour turbine à gaz, selon l'invention, comporte de manière classique une source d'énergie à courant continu désignée par la référence générale 1.

Cette source d'énergie peut présenter une structure classique connue dans l'état de la technique et ne sera donc pas décrite dans le détail.

On notera cependant qu'elle peut être constituée par une source d'énergie associée à des moyens particuliers de contrôle de la charge de moyens de stockage d'énergie, comme cela est décrit dans le document français précité.

Dans l'exemple de réalisation décrit en regard de cette Fig.1, ces moyens de stockage d'énergie comprennent un premier condensateur désigné par la référence générale 2, connecté aux bornes de sortie de la source d'énergie.

Par ailleurs, ce générateur comporte également des moyens de raccordement 3 de ce condensateur de stockage d'énergie au reste des circuits du générateur.

Ces moyens de raccordement peuvent être constitués par exemple par un éclateur à gaz de type classique ou encore par un ou plusieurs organes commutateurs à semiconducteur tels que par exemple des thyristors, dont le fonctionnement est déclenché par exemple par des moyens de comparaison de la tension aux bornes des moyens de stockage d'énergie à une valeur de référence comme cela est connu du document français précité.

La sortie de ces moyens de raccordement est reliée à un circuit de décharge comprenant des moyens à inductance de récupération d'énergie 4 en série avec une bougie d'allumage 5, une diode de roue libre 6 et une résistance 7 en parallèle, étant connectées aux bornes de ce circuit de décharge.

Selon l'invention, les moyens de stockage d'énergie comportent un second condensateur connecté en parallèle aux bornes des moyens à inductance 4 et des moyens de raccordement 3.

Ce second condensateur est désigné par la référence générale 8 sur cette figure et peut être un condensateur équivalent du point de vue électrique au premier condensateur 2 des moyens de stockage d'énergie.

Le fonctionnement de ce générateur est le suivant :

### 1) Phase de charge des moyens de stockage d'énergie.

Lorsque le fonctionnement de la source d'énergie est déclenché, les deux condensateurs 2 et 8 des moyens de stockage d'énergie se chargent sous la même tension de sortie de la source. Le premier condensateur 2 est connecté directement entre les bornes de sortie de la source d'énergie, tandis que le second condensateur 8 est connecté à ces bornes de sortie de la source à travers la diode 6 et la résistance 7 en parallèle et les moyens à inductance 4. Aucune étincelle n'est amorcée entre les électrodes de la bougie 5 et les moyens de raccordement 3 ne sont pas déclenchés.

### 2) Déclenchement du fonctionnement des moyens de raccordement.

Le déclenchement du fonctionnement des moyens de raccordement 3 permet de connecter le second condensateur 8 aux moyens à inductance 4 pour former un circuit LC parallèle, de sorte qu'une tension inverse à celle présente aux bornes du second condensateur 8 apparaît aux bornes de ces moyens à inductance.

Les premier et second condensateurs 2 et 8 ayant été chargés sous la même tension, on conçoit que la tension entre les électrodes de la bougie est alors nulle, car la tension aux bornes des moyens à inductance 4 est de signe opposé à celui de la tension aux bornes du premier condensateur 2.

Cependant, du fait du déclenchement des moyens de raccordement 3, le second condensateur 8 et les moyens à inductance 4 formant un circuit LC parallèle, au fur et à mesure de la décharge du second condensateur dans l'inductance, la tension aux bornes de celle-ci diminue de sorte que la tension entre les électrodes de la bougie augmente jusqu'à la tension de charge du premier condensateur. La tension aux bornes des moyens à inductance 4 passe par O puis augmente en changeant de signe. En théorie, cette tension aux bornes des moyens à inductance 4 pourrait, aux chutes de tension du circuit près, augmenter jusqu'à une valeur égale à la valeur de la tension de charge du second condensateur.

On conçoit alors qu'après le passage par zéro de la tension aux bornes des moyens à inductance et l'inversion de signe de cette tension, la tension entre les électrodes de la bougie augmente, car la tension aux bornes des moyens à inductance s'ajoute à celle aux bornes du premier condensateur.

### 3) Amorçage de l'étincelle entre les électrodes de la bougie.

La tension entre les électrodes de la bougie augmentant progressivement, elle permet d'amorcer une étincelle entre celles-ci.

Le schéma électrique équivalent du générateur est alors celui illustré sur la Fig.2, car l'amorçage d'une étincelle entre les électrodes de la bougie provoque la fermeture du circuit passant par les premier et second condensateurs qui sont alors connectés en série, les moyens de raccordement 3 et les moyens à inductance 4 formant un circuit série connecté en parallèle aux bornes du second condensateur 8. Dans ce schéma équivalent, la diode 6 et la résistance 7 ont été supprimées pour des questions de clarté d'explication du fonctionnement.

Au vu de ce schéma équivalent représenté sur la Fig.2, on conçoit que le courant circulant entre les électrodes de la bougie est la somme des courants circulant dans les deux branches de circuit en parallèle, à savoir dans la branche comprenant le second condensateur 8 et dans la branche comprenant les moyens de raccordement 3 et l'inductance 4.

On conçoit alors que cette structure permet de résoudre les différents problèmes des générateurs de l'état de la technique dans lesquels la totalité du courant circulant entre les électrodes de la bougie passait dans les moyens de raccordement, ce qui obligeait soit à limiter ce courant, en fonction des caractéristiques de ces moyens de raccordement, soit à combiner plusieurs organes commutateurs à semi-conducteur par exemple, pour obtenir des moyens de raccordement pouvant supporter notamment une intensité déterminée en vue d'obtenir des caractéristiques de sortie prédéterminées du générateur.

De plus, cette structure particulière fonctionne également en doubleur de tension pour provoquer l'amorçage des étincelles par addition de la tension aux bornes du premier condensateur 2 et de la tension aux bornes des moyens à inductance 4, cette tension résultant du fonctionnement en circuit LC parallèle de la partie de circuit constituée par ces moyens à inductance 4, le second condensateur 8 et les moyens de raccordement 3.

Ceci permet de limiter la tension de sortie de la source et donc la tension appliquée aux bornes des moyens de raccordement lorsque ceux-ci sont bloqués.

On sait en effet que lorsque ces moyens de raccordement comprennent des organes commutateurs à semiconducteur, il est important de réduire la tension appliquée à ceux-ci lorsqu'ils sont bloqués afin de réduire leur auto-échauffement par courants de fuite.

On notera qu'il est également possible de prévoir des moyens à inductance comportant deux éléments en série et séparés, l'un disposé à la manière des moyens à inductance 4 représentés sur la Fig.1 et l'autre disposé en série avec la bougie d'allumage 5, le second condensateur 8 étant alors raccordé au point milieu entre ces deux éléments d'inductance.

Dans ce cas, l'élément d'inductance en série avec la bougie sert à contrôler le courant circulant dans celle-ci.

## Revendications

1. Générateur d'allumage haute énergie notamment pour turbine à gaz, du type comportant une source d'énergie (1) raccordée à un circuit de charge de moyens de stockage d'énergie comprenant un premier condensateur de stockage (2) et des moyens de raccordement (3) de ces moyens de stockage à un circuit de décharge comportant en série des moyens à inductance de récupération d'énergie (4) et une bougie d'allumage (5) et aux bornes duquel sont connectés des moyens de roue libre (6) et une résistance (7) en parallèle, de manière à engendrer des étincelles entre les électrodes de la bougie, caractérisé en ce que les moyens de stockage d'énergie comprennent un second condensateur (8) connecté en parallèle aux bornes de ces moyens de raccordement (3) et d'au moins une partie des moyens à inductance (4).

2. Générateur selon la revendication 1, caractérisé en ce que les moyens à inductance comprennent deux éléments d'inductance séparés, connectés en série et en ce que le second condensateur (8) est raccordé au point milieu entre ces deux éléments.

3. Générateur selon l'une quelconque des revendications précédentes, caractérisé en ce que les moyens de raccordement comprennent au moins un organe commutateur à semi-conducteur.

4. Générateur selon l'une quelconque des revendications précédentes, caractérisé en ce que les premier et second condensateurs (2,8) sont équivalents du point de vue électrique.

## Patentansprüche

1. Hochenergiezündgenerator, insbesondere für eine Gasturbine,von dem Typ, der eine Energiequelle (1), die mit einer Ladeschaltung, einer Energiespeichereinrichtung verbunden ist, die einen ersten Speicherkondensator (2) aufweist, und eine Verbindungseinrichtung (3) der Speichereinrichtung mit einer Entladeschaltung in Serie mit einer Induktanzeinrichtung für die Rückgewinnung der Energie (4) und eine Zündkerze (3) aufweist, an deren Anschlüsse eine Diode (6) und ein damit parallel geschalteter Widerstand (7) angeschlossen sind, in der Weise, daß Funken zwischen den Elektroden der Zündkerze erzeugt werden, **dadurch gekennzeichnet, daß** die Energiespeichereinrichtung einen zweiten Kondensator (8) aufweist, der zu den Anschlüssen der Verbindungseinrichtung (3) und wenigstens einem Teil der Induktanzeinrichtung (4) parallel geschaltet ist.

2. Generator nach Anspruch 1, **dadurch gekennzeichnet, daß** die Induktanzeinrichtung zwei separate Induktanzelemente umfaßt, die in Serie geschaltet sind, und daß der zweite Kondensator (8) an einem Punkt zwischen den beiden Elementen angeschlossen ist.

3. Generator nach einem der vorhergehenden Ansprüche, **dadurch gekennzeichnet, daß** die Verbindungseinrichtung mindestens ein Halbleiter-Kommutatorelement umfaßt.

4. Generator nach einem der vorhergehenden Ansprüche, **dadurch gekennzeichnet, daß** der erste und der zweite Kondensator (2, 8) elektrisch gesehen äquivalent sind.

## Claims

1. A high energy ignition generator, particularly for gas turbine, of the type comprising a power source (1) connected to a circuit for charging energy storage means comprising a first storage capacitor (2) and means for connecting said storing means to a discharging circuit comprising, in series relation, energy recovering inductance means (4) and an ignition spark plug (5), the discharging circuit having terminals across which are connected free wheel means (6) in parallel with a resistor (7), so as to generate sparks between the electrodes of the spark plug, characterized in that the energy storage means comprise a second capacitor (8) connected in parallel to the terminals of said connecting means (3) and of at least part of the inductance means (4).

2. Generator according to claim 1, characterized in that the inductance means comprise two separate inductance elements, connected in series relation, and in that the second capacitor (8) is connected to the mid point between the two elements.

3. Generator according to any one of the preceding claims, characterized in that the connecting means comprise at least a semi-conductor switch unit.

4. Generator according to any one of the preceding claims, characterized in that the first and second capacitors (2,8) are electrically equivalent.
